**Europäisches Patentamt**

**European Patent Office**

**Office européen des brevets**

(19)

(11) Veröffentlichungsnummer: **0 172 327**
**B1**

(12)

# EUROPÄISCHE PATENTSCHRIFT

(45) Veröffentlichungstag der Patentschrift:
29.11.89

(51) Int. Cl.⁴: **H 01 L 29/08**

(21) Anmeldenummer: **85106751.2**

(22) Anmeldetag: **02.09.81**

(60) Veröffentlichungsnummer der früheren Anmeldung
nach Art. 76 EPÜ: **0048358**

(54) Integrierbare Leistungstransistoranordnung.

(30) Priorität: **19.09.80 DE 3035462**

(43) Veröffentlichungstag der Anmeldung:
**26.02.86 Patentblatt 86/9**

(45) Bekanntmachung des Hinweises auf die Patenterteilung:
**29.11.89 Patentblatt 89/48**

(84) Benannte Vertragsstaaten:
**DE FR GB IT**

(56) Entgegenhaltungen:
**DE-A- 2 400 673**
**DE-A- 2 554 612**
**US-A- 3 936 863**

**IEEE JOURNAL OF SOLID-STATE CIRCUITS, Band
SC-13, Nr. 3, Juni 1978, Seiten 307-319, New York, US; B.
MURARI "Power integrated circuits: Problems,
tradeoffs and solutions"**

(73) Patentinhaber: **Siemens Aktiengesellschaft,
Wittelsbacherplatz 2, D-8000 München 2 (DE)**

(72) Erfinder: **Mahrla, Peter, Dipl.-Phys.,
Geiselgasteigstrasse 96, D-8000 München 90 (DE)**

ACTORUM AG

## Beschreibung

Die Erfindung betrifft eine integrierbare Leistungstransistoranordnung mit mehrern bipolaren parallelgeschalteten Teil-Leistungstransistoren nach dem Oberbegriff des Patentanspruchs 1.

Beim Betrieb von bipolaren Leistungstransistoren ist die Schaffung einer gleichmässigen Stromverteilung über den Gesamttransistor von grosser Bedeutung hinsichtlich Betriebssicherheit und Lebensdauer eines solchen Bauelementes.

Bei bipolaren Leistungstransistoren entsteht aufgrund des negativen Temperaturkoeffizienten der Basis-Emitter-Spannung eine laterale thermische Instabilität.

Für die Abhängikeit der Kollektorstromdichte $J_C$ von der Temperatur T und der Basis-Emitter-Spannung $U_{BE}$ gilt näherungsweise:

$$J_C = J_{Co} \cdot \exp{(q.U_{BE} - E_g)/kT)}$$
$J_{Co}$ = Proportionalitätsfaktor
q = Elementarladung
$E_g$ = Bandabstand, bei Silicium ca. 1,1 EV
k = Boltzmannkonstante

Erhöht sich in einem Transistor lokal die Temperatur relativ zur Umgebung, so resultiert bei fester Basis-Emitter-Spannung hieraus gemäss obiger Gleichung eine Erhöhung der lokalen Stromdichte. Dies führt zu einer ebenfalls lokalen Erhöhung der Freisetzung von Wärme als Verlustleistung an der Kollektor-Basis-Sperrschicht und im hochohmigen Teil des Kollektors. Durch die dadurch bedingte lokale Temperaturerhöhung wird ein Rückkopplungsmechanismus in Gang gesetzt, der zu einer Stromeinschnürung im Transistor führt. Die damit verbundene hohe lokale Wärmefreisetzung bedingt häufig eine irreversible Schädigung des Transistors, was zum Ausfall des Bauelements führt. Derartigen Temperaturüberhöhungen im Transistor muss durch eine geeignete Stromstabilisierung begegnet werden.

Aus IEEE Journal of Solid State Circuits, Vol. SC-13, No. 3, pages 307 to 319, June 78 ist es bekannt, eine Strombegrenzung in integrierten Leistungstransistoren dadurch vorzunehmen, dass die Emitterzone in mehrere Bereiche aufgeteilt ist, wobei der als Emitter hauptsächlich wirksame Bereich in der Nähe des Basisanschlusses nicht kontaktiert ist, sondern über mehrere, als Vorwiderstände wirkende Bereiche der Emitterzone mit kontaktierten Bereichen der Emitterzone verbunden ist, dergestalt, dass jedem Teilbereich der wirksamen Emitterzone ein Vorwiderstand und ein Anschluss zugeordnet ist. Durch den Spannungsabfall über diese Vorwiderstände wird eine gleichmässige Stromverteilung über die einzelnen Teilbereiche der wirksamen Emitterzone erzielt, wobei der positive Temperaturkoeffizient des Emittervorwiderstandes unterstützend wirkt. Durch die in der genannten Literaturstelle dargestellte Transistorstruktur ist ausserdem auch ein Basisvorwiderstand neben dem Emittervorwiderstand gegeben. Der Basisvorwiderstand spielt jedoch neben dem Emittervorwiderstand keine entscheidende Rolle. Der Einbau von Emittervorwiderständen bedingt jedoch neben einer zusätzlich auftretenden Verlustleistung an den Emittervorwiderständen eine Erhöhung der Kollektor-Emitter-Rest- und Sättigungsspannung.

Aufgabe der Erfindung ist es daher, einen Leistungstranssitor anzugeben, der einerseits eine hinreichend gleichmässige Stromverteilung aufweist und andererseits eine möglichst geringe Sättigungs- bzw. Restspannung und Verlustleistung hat.

Dieser Aufgabe wird bei einer integrierbaren Leistungstransistoranordnung der eingangs erwähnten Art erfindungsgemäss durch die Merkmale des kennzeichnenden Teils des Patentanspruchs 1 gelöst.

Ausgestaltungen des Erfindungsgedankens sind in Unteransprüchen gekennzeichnet.

Bei einer erfindungsgemässen integrierbaren Leistungstransistoranordnung mit den Merkmalen des Patentanspruches 1 fliesst der grösste Teil des Basisstromes über die Basisvorwiderstände und der Spannungsabfall über den Emitterbereich ist klein gegenüber der Spannung zwischen aktivem Basisbereich und kontaktiertem Basisbereich.

Eine im Sinn der Aufgabe der Erfindung besonders günstige Ausgestaltung besteht darin, die Basisvorwiderstände so zu dimensionieren, dass die Spannung zwischen aktivem Basisbereich und kontaktiertem Basisbereich etwa doppelt so gross oder grösser als der Spannungsabfall über den Emitterbereich ist.

Zusätzlich besitzen die anstelle von Emittervorwiderständen zwischen wirksamen Emitterbereich und kontaktiertem Emitterbereich zwischen kontaktierten Basisbereichen und aktiven Basisbereichen angeordneten Basisvorwiderständen eine analoge Wirkung bezüglich der Wirkung von Emittervorwiderständen, nämlich eine gleichmässige Verteilung des Basisstromes und damit auch des Emitterstromes. Der positive Temperaturkoeffizient der Basisvorwiderstände unterstützte diese Massnahme.

Durch Anbringen von Basisvorwiderständen anstelle von Emittervorwiderständen kann in vorteilhafterweise gleichzeitig eine zusätzliche Verlustleistung an den Emittervorwiderständen sowie eine Erhöhung der Kollektor-Emitter-Restspannung und der Sättigungsspannung vermieden werden.

Es ist vorteilhaft, dass die Basisvorwiderstände durch Verbindungszonen zwischen kontaktiertem Basisbereich und aktiven Basisbereichen derart verwirklicht werden, dass die Verbindungszonen vom gleichen Dotierungstyp sind wie die Basiszonen.

Diese Vorwiderstände lassen sich durch Diffusionen bzw. Implantationen erzielen, die bereits in der Prozessfolge enthalten sind, die zur Herstellung der übrigen, in der integrierten Schaltung vorhandenen Bauelemente erforderlich sind, so dass keine zusätzlichen Prozessschritte notwendig werden.

Zur Herstellung eines erfindungsgemässen integrierbaren Leistungstransistors ist es auch vorteilhaft, dass in ein Substrat z.B. bestehend aus p-dotiertem Silicium, n+-dotierte Bereiche als Buried Layer eingebracht werden, dass darüber eine Schicht z.B. bestehend aus n-dotiertem Silicium epitaktisch abgeschieden wird, dass in die epitaktisch abgeschiedene Schicht Isolationsdiffusionen und n+-dotierte Kollektortiefdiffusionen eingebracht werden, wobei die Reihenfolge dieser Diffusionen beliebig ist, dass danach in die epitaktische Schicht p-Dotierungen als Basiszone bzw. Basisvorwiderstände eingebracht werden, dass danach in die epitaktische Schicht n+-Dotierungen als Emitterzone sowie zum Zwecke einer guten Kontaktgabe der Kollektortiefdiffusionen eingebracht werden, dass Kontaktfenster hergestellt werden, dass Leitbahnen zur Kontaktierung angebracht werden. Die Dotierungen können hinsichtlich p und n auch spiegelbildlich erfolgen.

Nachfolgend wird die Erfindung anhand von in den Figuren der Zeichnung dargestellten Ausführungsbeispielen näher erläutert. Es zeigen:

Fig. 1 eine Draufsicht auf die Epitaxieschicht eines ersten Ausführungsbeispieles eines erfindungsgemässen integrierbaren Leistungstransistors vor Aufbringen von Oxidschichten und Leitbahnen,

Fig. 2 einen Querschnitt durch einen integrierbaren Leistungstransistor nach Fig. 1 längs der Linie II-II, nach Aufbringen von Oxidschichten und Leitbahnen,

Fig. 3 eine Draufsicht auf die Epitaxieschicht eines zweiten Ausführungsbeispiels eines erfindungsgemässen integrierbaren Leistungstransistors vor Aufbringen von Oxidschichten und Leitbahnen und

Fig. 4 einen Querschnitt durch einen integrierbaren Leistungstransistor nach Fig. 3 längs der Linie IV-IV nach Aufbringen von Oxidschichten und Leitbahnen.

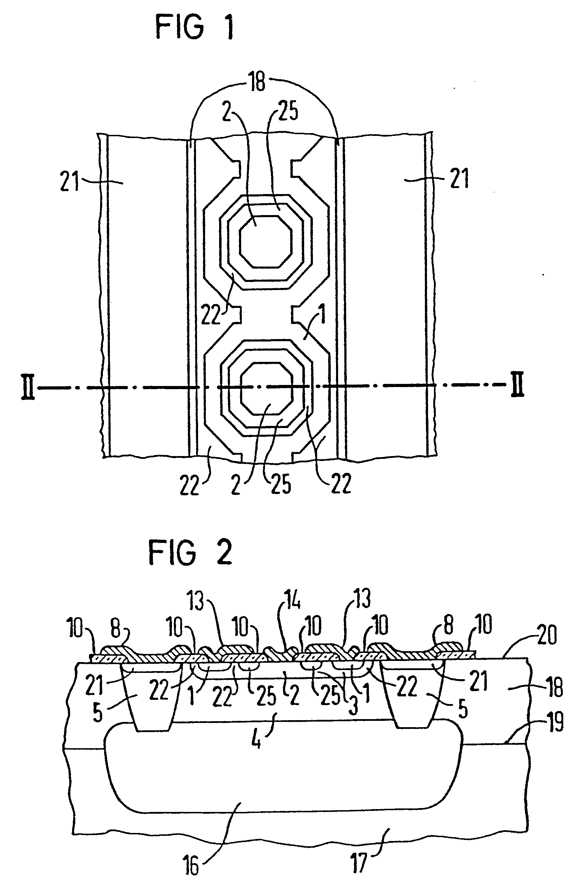

In den Fig. 1 bis 4 sind gleiche Elemente mit gleichen Ziffern belegt, weshalb die an einer Figur erläuterten Ziffern nicht an jeder Figur separat erläutert werden.

Die Teil-Leistungstransistoren sind über Leitbahnen parallel geschaltet, an die jeweils die einzelnen Teil-Basisbereiche und Teil-Emitterbereiche über zugeordnete Kontaktfenster angeschlossen sind. Nach Fig. 1 enthält ein Teil-Leistungstransistor eine zentral angeordnete, in einem nachfolgenden Prozessschritt mit der Basisleitbahn kontaktierte Basiszone 2, die von einem ringförmigen, konzentrischen Emitterbereich 1 umgeben ist, der sich an den Grenzen der Teil-Leistungstransistoren mit den benachbarten ringförmigen Emitterbereichen 1 durchdringt oder verbindet.

Die ringförmigen Emitterbereiche 1 sind in der aktiven Basiszone 22 gebildet, die sich über alle Teil-Leistungstransistoren streifenförmig erstreckt. In Fig. 1 erscheint die aktive Basiszone 22 von der zu kontaktierenden Basiszone 2 durch eine letztere umgebende ringförmige Zone 25 getrennt, auf die in Fig. 2 näher eingegangen wird.

Die aktive Basiszone 22 ihrerseits ist durch beidseitig zu ihr parallel verlaufende, an der Oberfläche der epitaktischen Schicht streifenförmig ausgebildete Zonen der epitaktischen Schicht von den ebenfalls jeweils in parallelen Streifen ausgebildeten Kollektor-Anschlussbereichen 21 getrennt.

Der Aufbau eines erfindungsgemässen Teil-Leistungstransistors wird anhand von Fig. 2 deutlich. In einem Substrat 17, das z.B. aus Saphir oder einem Halbleiter, insbesondere Silicium bestehen kann, sind Buried-Layer-Bereiche 16 eindotiert. Auf der Oberfläche 19 ist eine Epitaxieschicht 18 abgeschieden. Kollektor-Tiefdiffusionsbereiche 5 sind von der Oberfläche 20 so in die Epitaxieschicht 18 eingebracht, dass sie bis in die Buried-Layer 16 hineinragen. Oberhalb der Buried-Layer 16 zwischen den Kollektor-Tiefdiffusionsbereichen 5 befindet sich der Kollektorbereich 4. Darin eingebettet liegt der bis zur Oberfläche 20 der epitaktischen Schicht reichende Basisbereich, der die aktive Basiszone 22, die kontaktierte Basiszone 2 und die Basisvorwiderstände 3 enthält. Die Kontaktierung der Basiszone 2 erfolgt durch die Basisleitbahn 14. In die nicht kontaktierte Basiszone 22 ist wiederum die bis zur Oberfläche 20 reichende Emitterzone 1 eingebettet. Die Emitterzone 1 ist durch die Emitterleitbahn 13 kontaktiert. Zum Zwecke einer guten Kontaktgabe zwischen den Kollektorleitbahnen 8 und den Kollektor-Tiefdiffusionsbereichen 5 sind zusätzliche dotierte Bereiche 21 in die Kollektor-Tiefdiffusionsbereiche 5 eingebracht, deren Dotierung im allgemeinen der Emitterdotierung entspricht. Zu Zwecken der Isolation zwischen den einzelnen Transistorzonen und den zum Anschluss benötigten, darüber liegenden Leitbahnen 8, 13, 14 sind Oxidschichten 10 abgeschieden.

Zwischen der kontaktierten Emitterzone 1 und der kontaktierten Basiszone 2 ist eine ringförmige Zone 25 eindotiert, die im allgemeinen die gleiche Dotierung wie der Emitter aufweist, jedoch entweder potentialfrei ist oder aber an das Basispotential angeschlossen werden kann. Durch die ringförmige Zone 25 wird der Basisbereich teilweise eingeschnürt. Die Basisvorwiderstände 3 werden in diesem Ausführungsbeispiel durch die eingeengten Basisbereiche unterhalb der ringförmigen Zone 25 verwirklicht. Die Basisvorwiderstände 3, die in dieser Anordnung auch Basis-Pinchwiderstände genannt werden, weisen einen Flächenwiderstand von ca. 5 kOhm/cm² auf und lassen sich durch eine entsprechende Geometrie der Masken in ihrem Wert beeinflussen.

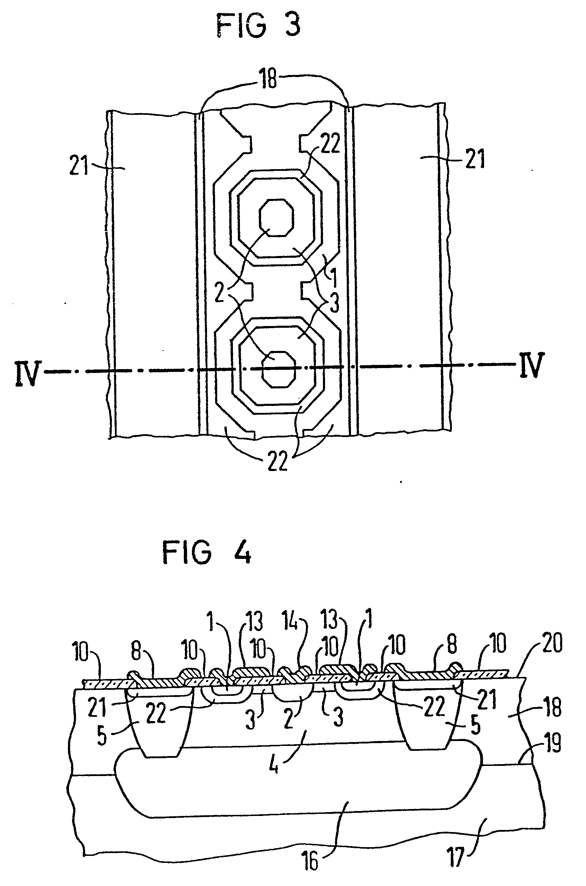

Das Ausführungsbeispiel nach Fig. 3 entspricht in der Draufsicht der Fig. 1, allerdings mit dem Unterschied, dass statt der Zonen 25 durch die bis zur Oberfläche 20 reichenden Basisvorwiderstände 3 erkennbar sind. Die nicht kontaktierte Basiszone 22 und die kontaktierte Basiszone 2 sind durch diese Vorwiderstände 3 miteinander verbunden, die im Ausführungsbeispiel ebenfalls ringförmig die kontaktierte Basiszone 2 umgeben und implantierte Hochohmwiderstände von 2 kOhm/cm² darstellen.

Der Schnitt nach Fig. 4 zeigt, dass in diesem Ausführungsbeispiel die kontaktierte und die aktive Basiszone 2 bzw. 22 zwar noch in einem Prozessschritt erzeugt werden, aber jeweils getrennte Zonen bilden, da keine Einschnürung des Basisbereiches erfolgt.

Als Hableitermaterial kann für die zwei Ausführungsbeispiele Silicium verwendet werden, in diesem Fall ist das Substrat 17 z.B. p-dotiert, die Buried-Layer 16 n+-dotiert, die Kollektor-Tiefdiffusionsbereiche sind n+-dotiert, ebenso wie die Zonen 21, die zum Anschluss der Kollektor-Tiefdiffusionsbereiche 5 an die Kollektorleitbahnen 8 dienen. Der Kollektor 4 sowie die gesamte Epitaxieschicht 18 sind n-dotiert, die Basisbereiche 2 bzw. 22 und die Basisvorwiderstände 3 sind jeweils p-dotiert, wobei im Falle von Fig. 4 die Basisvorwiderstände 3 als implantierte Hochohmwiderstände ausgebildet sind. Der Emitterbereich 1 sowie der Bereich 25 aus Fig. 1 und Fig. 2 sind n+-dotiert. P-Dotierung kann im allgemeinen durch Dotierung mit Bor erfolgen, während n- bzw. n+-Dotierung mittels Arsen erfolgen kann. Es können jedoch auch andere geeignete Dotiermittel wie auch Halbleitermaterialien verwendet werden. Ausserdem kann die Dotierung erfindungsgemässer Halbleiterleistungstransistoren auch hinsichtlich p und n vertauscht werden.

Durch die Verwendung der Basisvorwiderstände zur Stromstabilisierung tritt der Spannungsabfall über den Basisvorwiderständen nicht in der Kollektor-Emitter-Sättigungsspannung auf, sondern lediglich in der Steuerspannung zwischen Basis- und Emitteranschluss. Durch die erfindungsgemässe Verwendung von Basisvorwiderständen lassen sich nachteilige positive Temperaturkoeffizienten der Stromverstärkung teilweise kompensieren, und zwar durch den positiven Temperaturkoeffizienten des Basisvorwiderstandes. Eine besonders starke Temperaturkompensation ist durch Verwendung von Basis-Pinchwiderständen, wie sie in Fig. 1 und Fig. 2 dargestellt sind, möglich. Deren positiver Temperaturkoeffizient liegt nämlich in weiten Bereichen deutlich über dem der Stromverstärkung. Hierdurch wird zusätzlich eine Temperaturstabilisierung im Leistungstransistor erreicht, da an den heissen Stellen die Kollektorstromdichte und damit die Wärmefreisetzung durch den erhöhten Pinchwiderstand vermindert wird.

Bei diskreten Leistungstransistoren sind gleiche Strukturen wie in Fig. 1 bis Fig. 4 dargestellt, realisierbar, wobei Kollektor-Tiefdiffusionen entfallen.

Auch das Ausführungsbeispiel nach Fig. 3 und Fig. 4 bewirkt durch den positiven Temperaturkoeffizienten der implantierten Hochohmwiderstände ebenfalls eine Kompensation der Temperaturkoeffizienten der zugehörigen Stromverstärkung. Die Strukturen nach Fig. 2 und Fig. 4 sind bei doppelt eindiffundierten diskreten Leistungstransistoren ebenfalls prinzipiell realisierbar.

Besonders vorteilhaft lassen sich erfindungsgemässe Halbleiterleistungstransistoren für Anwendungen im niederfrequenten Bereich einsetzen.

## Patentansprüche

1. Integrierbarer Leistungstransistoranordnung mit mehrern bipolaren parallel geschalteten Teil-Leistungstransistoren, bei der auf einem Halbleitersubstrat eine die jeweilige Kollektorzone der Teil-Leistungstransistoren bildende epitaktische Schicht vorgesehen ist, bei der im Bereich der Grenzfläche zwischen Halbleitersubstrat und epitaktischer Schicht eine Buried-Layer-Zone für den jeweiligen Kollektor vorgesehen ist, bei der von der dem Haltleitersubstrat abgewandten Oberfläche der epitaktischen Schicht bis in die Buried-Layer-Zone reichende Kollektor-Anschlussbereiche verlaufen, bei der in der epitaktischen Schicht an der dem Halbleitersubstrat abgewandten Seiten eine den Teil-Leistungstransistoren gemeinsame Basiszone und in der Basiszone eine den Teil-Leistungstransistoren gemeinsame Emitterzone vorgesehen ist und bei der der jeweiligen Basis ein mitintegrierter Vorwiderstand vorgeschaltet ist, dadurch gekennzeichnet, dass die den Teil-Leistungstransistoren gemeinsame Basiszone (2, 22) je eine zentral angeordnete kontaktierte Basiszone (2) enthält, die von je einem ringförmigen konzentrischen, in der aktiven Basiszone (22) gebildeten Emitterbereich (1) umgeben ist, der sich an den Grenzen der Teil-Leistungstransistoren mit den benachbarten ringförmigen Emitterbereichen (1) durchdringt oder verbindet, und dass die den ringförmigen Emitterbereich (1) umgebende aktive Basiszone (22) mit der kontaktierten Basiszone (2) über einen diese ringförmig umgebenden integrierten Vorwiderstand (3) verbunden ist.

2. Integrierbare Leistungstransistoranordnung nach Anspruch 1, dadurch gekennzeichnet, dass der integrierte Vorwiderstand (3) durch eine die Zone zwischen kontaktierter (2) und aktiver Basiszone (22) einschnürende, die kontaktierte Basiszone (2) ringförmig umgebende Zone (25) vom gleichen Dotierungstyp wie der Emitterbereich (1) gebildet ist.

3. Integrierbare Leistungstransistoranordnung nach Anspruch 1 bis 2, dadurch gekennzeichnet, dass die die kontaktierte Basiszone (2) umgebende Zone (25) auf Basispotential liegt.

4. Integrierbare Leistungstransistoranordnung nach Anspruch 1 bis 2, dadurch gekennzeichnet, dass die die kontaktierte Basiszone (2) umgebende Zone (25) potentialfrei ist.

5. Integrierbare Leistungstransistoranordnung nach Anspruch 1 bis 4, dadurch gekennzeichnet, dass der integrierte Vorwiderstand (3) einen Widerstand von etwa 5 kOhm/cm² besitzt.

6. Integrierbare Leistungstransistoranordnung nach Anspruch 1, dadurch gekennzeichnet, dass der integrierte Vorwiderstand (3) durch Implantation in der epitaktischen Schicht (4) gebildet ist.

7. Integrierbare Leistungstransistoranordnung nach Anspruch 6, dadurch gekennzeichnet, dass der integrierte Vorwiderstand (3) einen Widerstand von etwa 2 kOhm/cm² besitzt.

8. Integrierbare Leistungstransistoranordnung nach Anspruch 1 bis 7, dadurch gekennzeichnet, dass in den Kollektor-Anschlussbereichen (21) dotierte Zonen (5) vorgesehen sind, die von der dem Halbleitersubstrat abgewandten Oberfläche (20) der epitaktischen Schicht (18) bis in die Buried-Layer-Zone (16) reichen und zur Kollektorkontaktierung dienen.

## Claims

1. Integrable power transistor device having several bipolar parallel-connected component power transistors, in which device an epitaxial layer which forms the particular collector region of the component power transistors is provided on a semiconductor substrate, in which device a buried-layer zone for the particular collector is provided in the region of the boundary surface between the semiconductor substrate and the epitaxial layer, in which device collector terminal regions reaching as far as into the buried-layer zone extend from the surface of the epitaxial layer averted from the semiconductor substrate, in which device a base region common to the component power transistors is provided in the epitaxial layer on the side averted from the semiconductor substrate, and an emitter region common to the component power transistors is provided in the base region, and in which device an integrated series resistor is connected upstream of the particular base, characterized in that the base region (2, 22) common to the component power transistors contains in each case a centrally arranged contacted base region (2), which is surrounded in each case by an annular, concentric emitter region (1), which is formed in the active base region (22) and penetrates or connects at the boundaries of the component power transistors with the neighbouring annular emitter regions (1), and in that the active base region (22) surrounding the annular emitter region (1) is connected to the contacted base region (2) via an integrated series resistor (3) surrounding the latter in an annular fashion.

2. Integrable power transistor device according to Claim 1, characterized in that the integrated series resistor (3) is formed by a zone (25) of the same doping type as the emitter region (1), which zone narrows the zone between the contacted base region (2) and active base region (22), and surrounds the contacted base region (2) in an annular fashion.

3. Integrable power transistor device according to Claim 1 to 2, characterized in that the zone (25) surrounding the contacted base region (2) is at base voltage.

4. Integrable power transistor device according to Claim 1 to 2, characterized in that the zone (25) surrounding the contacted base region (2) is potentialfree.

5. Integrable power transistor device according to Claim 1 to 4, characterized in that the integrated series resistor (3) has a resistance of approximately 5 kOhm/cm².

6. Integrable power transistor device according to Claim 1, characterized in that the integrated series resistor (3) is formed by implantation in the epitaxial layer (4).

7. Integrable power transistor device according to Claim 6, characterized in that the integrated series resistor (3) has a resistance of approximately 2 kOhm/cm².

8. Integrable power transistor device according to Claim 1 to 7, characterized in that doped zones (5) are provided in the collector terminal regions (21), which reach from the surface (20) of the epitaxial layer (18), which surface is averted from the semiconductor substrate, as far as into the buried-layer zone (16), and serve to contact the collector.

## Revendications

1. Dispositif intégrale à transistors de puissance, comportant plusieurs bipolaires élémentaires de puissance branchés en parallèle, et dans lequel sur un substrat semiconducteur se trouve prévue une couche épitaxiale constituant la zone respective de collecteur des transistors élémentaires de puissance, et dans lequel une zone formant couche ensevelie est prévue pour chaque collecteur, dans la zone de l'interface entre la substrat semiconducteur et la couche épitaxiale, et dans lequel des régions de raccordement des collecteurs s'étendent à partir de la surface, tournée à l'opposé du substrat semiconducteur, de la couche épitaxiale jusqu'à l'intérieur de la zone formant couche ensevelie, et dans lequel une zone de base commune aux transistors élémentaires de puissance est prévue dans la couche épitaxiale, sur le côté tourné à l'opposé du substrat semiconducteur, et une zone d'émetteur commune aux transistors élémentaires de puissance est prévue dans la zone de base, et dans lequel une résistance additionnelle, intégrée conjointement, est branchée en amont de la base respective, caractérisé par le fait que la zone de base (2, 22), qui est commune aux transistors élémentaires de puissance, contient respectivement une zone de base (2) raccordée par contact, qui est disposée centralement et est entourée respectivement par une zone annulaire concentrique d'émetteur (1), qui est formée dans la zone de base active (22) et s'étend au niveau des limites des transistors élémentaires de puissance avec les zones annulaires voisines d'émetteur (1) ou est reliée à ces zones, et que la zone active de base (22), qui entoure la zone annulaire d'émetteur (1), est reliée à la zone de base (2) raccordée par contact, par l'intermédiaire d'une résistance additionnelle intégrée (3) entourant cette zone de base avec une forme annulaire.

2. Dispositif intégrable à transistors de puissance suivant la revendication 1, caractérisé par le fait que la résistance additionnelle intégrée (3) est formée par une zone (25), qui est insérée entre la zone de base (2) raccordée par contact et la zone de base active (22), entoure avec une forme annulaire la zone de base (2) raccordée par contact et possède le même type de dopage que la région d'émetteur (1).

3. Dispositif intégrable à transistors de puissance suivant les revendications 1 et 2, caractérisé par le fait que la zone (25), qui entoure la zone de base (2) raccordée par contact, est placée au potentiel de base.

4. Dispositif intégrable à transistors de puissance suivant les revendications 1 et 2, caractérisé par le fait que la zone (25), qui entoure la zone de base (2) raccordée par contact, est à un potentiel libre.

5. Dispositif intégrable à transistors de puissance suivant les revendications 1 à 4, caractérisé par le fait que la résistance additionnelle intégrée (3) possède une valeur résistive égale à environ 5 k.ohms/cm².

6. Dispositif intégrable à transistors de puissance suivant la revendication 1, caractérisé par le fait que la résistance additionnelle intégrée (3) est formée par implantation dans la couche épitaxiale (4).

7. Dispositif intégrable à transistors de puissance suivant la revendication 6, caractérisé par le fait que la résistance additionnelle intégrée possède une valeur résistive égale à environ 2 k.ohms/cm².

8. Dispositif intégrable à transistors de puissance suivant les revendications 1 à 7, caractérisé par le fait que dans les régions (21) de raccordement des collecteurs, il est prévu des zones dopées (5), qui s'étendent depuis la surface (20), opposée au substrat semiconducteur, de la couche épitaxiale (18) jusque dans la zone formant couche ensevelie (16) et sont utilisées pour réaliser le raccordement du collecteur.

## FIG 1

## FIG 2

# FIG 3

# FIG 4